# EUROPEAN PATENT APPLICATION

(11) **EP 2 559 717 A1**
(43) Date of publication of application: **20.02.2013**
(21) Application number: 11768893.7
(22) Date of filing: 13.04.2011
(51) Int. Cl.: C08G 59/18, C08G 59/42, C09J 7/00, C09J 9/02, C09J 11/06, C09J 163/00, C09J 201/00, H01B 1/22, H01B 5/16

(54) **CURABLE RESIN COMPOSITION, ADHESIVE EPOXY RESIN PASTE, DIE-BONDING AGENT, NON-CONDUCTIVE PASTE, ADHESIVE EPOXY RESIN FILM, NON-CONDUCTIVE EPOXY RESIN FILM, ANISOTROPIC CONDUCTIVE PASTE, AND ANISOTROPIC CONDUCTIVE FILM**

(30) Priority: 13.04.2010 JP 2010092671
(71) Applicant: Sony Chemical & Information Device Corporation, Tokyo 141-0032 (JP)
(72) Inventor: NAMIKI, Hidetsugu, Kanuma-shi Tochigi 322-8503 (JP); ISHIGAMI, Akira, Kanuma-shi Tochigi 322-8503 (JP); UMAKOSHI, Hideaki, Kanuma-shi Tochigi 322-8503 (JP); KANISAWA, Shiyuki, Kanuma-shi Tochigi 322-8503 (JP)
(74) Representative: Müller - Hoffmann & Partner
(86) International application number: PCT/JP2011/059193
(87) International publication number: WO 2011/129372

(57) **Abstract**

To provide a curable resin composition that can improve resistant properties such as thermal impact resistance even in a high-temperature and high-humidity environment and has a high adhesive property, high conduction reliability and superior crack resistant property. The curable resin composition contains an epoxy resin and an epoxy resin-use curing agent, and is characterized in that a difference between a maximum value of tan δ in a viscoelastic spectrum and a value of the tan δ at -40°C thereof is 0.1 or more.

## Description

### Field of the Invention

This invention relates to a curable resin composition having a high adhesive property, a high conductive reliability and a superior crack resistance that can improve resistance such as thermal impact resistance in a high-temperature high-humidity environment, and also concerns an adhesive epoxy resin paste, a die bonding agent, a non-conductive paste, an adhesive epoxy resin film, a non-conductive epoxy resin film, an anisotropic conductive paste and an anisotropic conductive film.

The present application claims priority rights to JP Patent Application 2010-92671 filed in Japan on April 13, 2010, which is hereby incorporated by reference.

### Background of the Invention

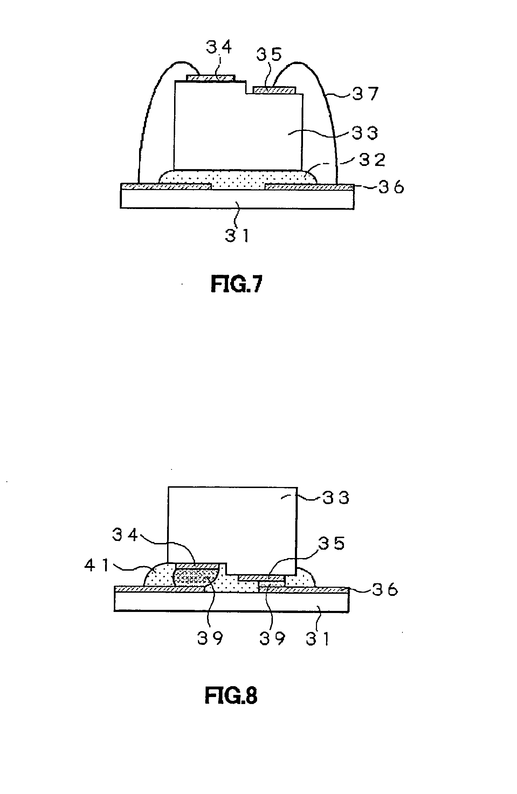

As a technical method for assembling chips, such as driver IC chips, LED elements, or the like, on a substrate, a wire bonding method has been used. As shown in Fig. 7, the wire bonding method forms an electrical bond between an element 33 and a substrate 31 by using a wire bond 37. In the bonding process between a connection terminal 36 of the element 33 and the substrate 31, a die bonding material 32 is used. However, in the method for providing the electrical bond by using the wire bond 37, there are risks of physical fracture and peeling of the wire bond 37 from an electrode (p-electrode 34 and n-electrode 35), and there have been demands for more reliable techniques. Moreover, since the bonding process between the element 33 and the substrate 31 is generally carried out in an oven curing process, the production takes a long period of time.

As a technical method without using the wire bond, as shown in Fig. 8, a method has been proposed in which a conductive paste 39, typically represented by silver paste, is used for the electrical bond between the element 33 and the substrate 31. However, this conductive paste 39 only has a weak adhesive strength, and needs to be reinforced by a sealing resin 41. Moreover, since the bonding process of the sealing resin 41 is carried out in an oven curing process, the production takes a long period of time.

As a technical method without using the conductive paste, a method has been proposed in which an anisotropic conductive adhesive agent, such as ACF, is used for the electrical connection and bond between the element 33 and the substrate 31. Since the anisotropic conductive adhesive agent requires only a short bonding process, good production efficiency is achieved. As the anisotropic conductive adhesive agent, in particular, epoxy resins, which are inexpensive, and superior in transparency, adhesive property, heat resistance, mechanical strength, electrical insulation, etc., are often used.

However, an anisotropic conductive adhesive agent, which uses a conventional adhesive agent composed of an epoxy resin as a base resin, has a high elastic modulus and is difficult to provide stress relaxation; therefore, when subjected to reliability tests, such as a lead-free solder-use reflow test, a thermal impact test (TCT), high- temperature/ high-humidity tests, a pressure cocker (PCT test), or the like, problems tend to arise due to an internal stress caused by a difference in thermal expansion ratios relative to the connection substrate in which an increase in conduction resistance, peeling on the bonded surface and cracks in the adhesive agent (binder) occur.

### Prioor-Art Documents

### Patent Document

PTL 1: Japanese Patent Application Laid-Open No. 2009-13416
PTL 2: Japanese Patent Application Laid-Open No. 2005-120357
PTL 3: Japanese Patent Application Laid-Open No. 05-152464
PTL 4: Japanese Patent Application Laid-Open No. 2003-26763

### Summary of the Invention

An object of the present invention is to provide a curable resin composition having a high adhesive property, a high conductive reliability and a superior crack resistance that can improve resistance such as thermal impact resistance in a high-temperature high-humidity environment, an adhesive epoxy resin paste, a die bonding agent, a non-conductive paste, an adhesive epoxy resin film, a non-conductive epoxy resin film, an anisotropic conductive paste and an anisotropic conductive film.

A curable resin composition in accordance with the present invention is a curable resin composition containing an epoxy resin and an epoxy resin curable agent, which is characterized in that a difference between a maximum value of tan δ in a viscoelastic spectrum of the curable resin composition and a value of the tan δ at -40°C is 0.1 or more.

Moreover, the curable resin compound in accordance with the present invention is characterized in that the maximum value of the tan δ is included in a range from -40°C or more to 100°C or less. The curable resin compound in accordance with the present invention is also characterized in that a difference between the maximum value of tan δ and the value of the tan δ at -40°C is 0.1 or more to 0.5 or less. Furthermore, the curable resin compound in accordance with the present invention is characterized by containing 4.5 wt% or more of acid anhydride having a ring structure of 6 or more ring members. The curable resin compound in accordance with the present invention is also characterized by containing 4.5 wt% or more of glutaric anhydride. Moreover, the curable resin compound in accordance with the present invention is characterized by containing 5 to 50 wt% of a high molecular weight component having at least a molecular weight of 5000 or more. The curable resin compound in accordance with the present invention is characterized in that the high molecular weight component has a Tg of 50°C or less. The curable resin compound in accordance with the present invention is characterized in that the high molecular weight component has a reactive functional group.

An adhesive epoxy resin paste in accordance with the present invention is characterized by being composed of the above-mentioned curable resin compound.

A die bonding agent in accordance with the present invention is characterized by being composed of the above-mentioned adhesive epoxy resin paste.

A non-conductive paste in accordance with the present invention is characterized by being composed of the above-mentioned adhesive epoxy resin paste.

An adhesive epoxy resin film in accordance with the present invention is characterized by being prepared by molding the above-mentioned curable resin composition into a film shape.

A non-conductive epoxy resin film in accordance with the present invention is characterized by being composed of the above-mentioned adhesive epoxy resin film.

An anisotropic conductive paste in accordance with the present invention is characterized by allowing the above-mentioned adhesive epoxy resin paste to contain conductive particles.

An anisotropic conductive film in accordance with the present invention is characterized by allowing the above-mentioned adhesive epoxy resin film to contain conductive particles.

### Effects of Invention

The curable resin composition in accordance with the present invention satisfies that a difference between a maximum value of tan δ in a viscoelastic spectrum of the curable resin composition and a value of the tan δ at -40°C is 0.1 or more. By using such a curable resin composition, even when an assembled product obtained by assembling chip components on a circuit substrate is subjected to a thermal impact or the like in a high-temperature high-humidity environment, it is possible to maintain high conduction reliability between the circuit substrate and the chip components and also to ensure a superior crack resistant property. Brief Description of Drawings

Figure 1 is a drawing that schematically illustrates an acid anhydride having 6 or more ring members, which is contained in a curable resin composition in accordance with the present embodiment.
Figure 2 is a cross-sectional view that schematically illustrates an anisotropic conductive film using the curable resin compound.
Figure 3 is a graph showing a storage elastic modulus E' relative to a temperature of an anisotropic paste using the curable resin compound.
Figure 4 is a graph showing a storage elastic modulus E' and a loss elastic modulus E" relative to a temperature of an anisotropic paste using the curable resin compound.
Figure 5 is a graph showing a tangent of loss angle tan δ relative to a temperature of an anisotropic paste using the curable resin compound.
Figure 6 is a graph showing a tangent of loss angle tan δ relative to a temperature of an anisotropic paste using the curable resin compound.
Figure 7 is a cross-sectional view schematically illustrating a structure of a light emitting device formed by joining elements on a substrate by using a die bonding adhesive agent.
Figure 8 is a cross-sectional view schematically illustrating a structure of a light emitting device formed by joining elements on a substrate by using a flip chip assembling process.

### Detailed Description of the Invention

Referring to drawings, the following description will discuss examples of specific embodiments (hereinafter, referred to as "present embodiments") of a curable resin composition to which the present invention is applied in accordance with the following sequence.
1. Curable Resin Composition
   1-1. Epoxy Resin
   1-2. Curing Agent
   1-3. High Molecular Weight Component
   1-4. Conductive Particles
   1-5. Other Additives
   1-6. Producing Method for Curable Resin Composition
2. Other Embodiments Using Curable Resin Composition
3. Examples

### <1. Curable Resin Composition>

A curable resin composition in accordance with the present embodiment contains an epoxy resin and an epoxy resin curing agent, and has a difference between a maximum value of tan δ in a viscoelastic spectrum thereof and a value of the tan δ at -40°C is 0.1 or more.

The tan δ (tangent of loss angle) refers to a value calculated from an equation tan δ = E"/E', which is 0 or more and less than 1. In this case, E" represents a loss elastic modulus, and E' represents a storage elastic modulus. For example, tan δ is calculated from the above-mentioned equation based upon values of a viscoelastic spectrum of a storage elastic modulus (E') and a viscoelastic spectrum of a loss elastic modulus (E") measured at a predetermined frequency within a predetermined temperature range by using a viscoelasticity measuring apparatus. As the value of tan δ becomes greater, it is indicated that more energy can be absorbed, and even upon application of a thermal impact, or the like, in a high-temperature high-humidity environment, the peeling resistance of a bonded surface and the crack resistance of a binder can be improved.

In the case when the curable resin composition has too large a difference between a maximum value of tan δ and a value of the tan δ at -40°C, a sticker becomes too soft with the result that the sticker is elongated at high temperatures to easily cause a peeling resulting in, for example, an increase in conduction resistance and a subsequent degradation of connection reliability. In contrast, in the case when the curable resin composition has too small a difference between a maximum value of tan δ and a value of the tan δ at -40°C, the sticker becomes too hard, and upon application of a thermal impact, or the like, in a high-temperature high-humidity environment, a problem arises in that a peeling occurs on a bonded surface and a crack is generated in the adhesive agent. Therefore, from both of viewpoints of good crack resistant property and high conduction reliability, the curable resin composition is allowed to have a difference of 0.1 or more between a maximum value of tan δ and a value of the tan δ at -40°C. In this manner, by allowing the curable resin composition to satisfy that a difference between a maximum value of tan δ in a viscoelastic spectrum of the curable resin composition and a value of the tan δ at -40°C is 0.1 or more, the difference in viscoelasticity caused by temperatures is made greater so that the stress relaxation can be improved. With this arrangement, for example, even upon application of a thermal impact, or the like, in a high-temperature high-humidity environment, high conduction reliability between the circuit substrate and chip members can be maintained, and the crack resistance as well as the peeling resistance can be maintained in a good state.

Moreover, in the curable resin composition, the maximum value of tan δ is preferably included within a range from -40°C or more to 100°C or less. This temperature range is set so as to ensure resistance under applied environments, and corresponds to a temperature range of a thermal impact test, which will be described later.

Moreover, from the viewpoints of improving both of the crack resistant property and conduction reliability, the curable resin composition is preferably designed to have a difference of 0.1 or more to 0.5 or less between a maximum value of tan δ and a value of the tan δ at -40°C.

### <1-1. Epoxy Resin>

As the epoxy resin, an epoxy-based resin mainly composed of an alicyclic epoxy compound, a heteroring-based epoxy compound, a hydrogenated epoxy compound or the like is preferably used.

As the alicyclic epoxy compound, such compounds having two or more epoxy groups in a molecule are preferably used. These alicyclic epoxy compounds may be a liquid state or a solid state. Specific examples thereof include: glycidyl hexahydro bisphenol A, 3,4-epoxycyclohexenyl methyl-3'-4'-epoxycyclohexene carboxylate, etc. Among these alicyclic epoxy compounds, from the viewpoints of ensuring light transparency applicable to assembling processes for LED elements in the cured product and of superior rapid curing property, glycidyl hexahydro bisphenol A or 3,4-epoxycyclohexenyl methyl-3'-4'-epoxycyclohexene carboxylate is preferably used.

As the heteroring-based epoxy compound, epoxy compounds having a triazine ring are proposed, and more preferably, 1,3,5-tris(2,3-epoxypropyl)-1,3,5-triazine- 2,4,6-(1H, 3H, 5H)-trione may be used.

As the hydrogenated epoxy compound, hydrogen compounds of the above-mentioned alicyclic epoxy compounds, heteroring-based epoxy compound and the like, and other known hydrogenated epoxy resins may be used.

With respect to the alicyclic epoxy compound, the heteroring-based epoxy compound and the hydrogenated epoxy compound, one of these may be used alone, or two or more kinds of these may be used in combination. Moreover, in addition to these epoxy resin compounds, other epoxy compounds may be used in combination as long as the effects of the present invention are not impaired. Examples of the other epoxy compounds include: glycidyl ethers obtained by reacting epichlorohydrin with polyhydric phenols, such as bisphenol A, bisphenol F, bisphenol S, hexahydrobisphenol A, tetramethyl bisphenol A, diaryl bisphenol A, hydroquinone, catechol, resorcine, cresol, tetrabromo bisphenol A, trihydroxy bephenyl, benzophenone, bisresorcinol, bisphenol hexafluoroacetone, tetramethyl bisphenol A, tetramethyl bisphenol F, tris(hydroxyphenyl) methane, bixylenol, phenolnovolak, and cresolnovolak; or polyglycidyl ethers obtained by reacting epichlorohydrin with aliphatic polyhydric alcohols, such as glycerin, neopentylglycol, ethylene glycol, propylene glycol, ethylene glycol, hexylene glycol, polyethylene glycol, and polypropylene glycol; glycidyl ethers esters obtained by reacting epichlorohydrin with hydroxycarboxylic acids, such as p-oxybenzoic acid and β-oxynaphthoic acid; or polyglycidyl esters obtained from polycarboxylic acids, such as phthalic acid, methylphthalic acid, isophthalic acid, terephthalic acid, tetrahydrophthalic acid, hexahydrophthalic acid, endomethylene tetrahydrophthalic acid, endomethylene hexahydrophthalic acid, trimellitic acid, and polymerized aliphatic acid; glycidylaminoglycidyl ethers obtained from amino phenol and aminoalkyl phenol; glycidylaminoglycidyl esters obtained from aminobenzoic acid; glycidyl amines obtained from aniline, toluidine, tribromoaniline, xylylene diamine, diaminocyclohexane, bisaminomethyl cyclohexane, 4,4'-diaminodiphenyl methane, 4,4'-diaminodiphenyl sulfone, etc.; or known epoxy resins, such as epoxidized polyolefins.

### <1-2. Curing Agent>

As the curing agent, acid anhydrides, imidazole compounds, dicyanes, etc. are proposed. Among these curing agents, acid anhydrides that hardly cause discoloration of the cured products, such as in particular, alicyclic acid anhydride-based curing agents, are preferably used. More specifically, as described earlier, from the viewpoints of improving stress relaxation and consequently providing superior peeling resistance and crack resistance, among the alicyclic acid anhydride-based curing agents, acid anhydrides having a ring structure with 6 or more ring members are in particular preferable.

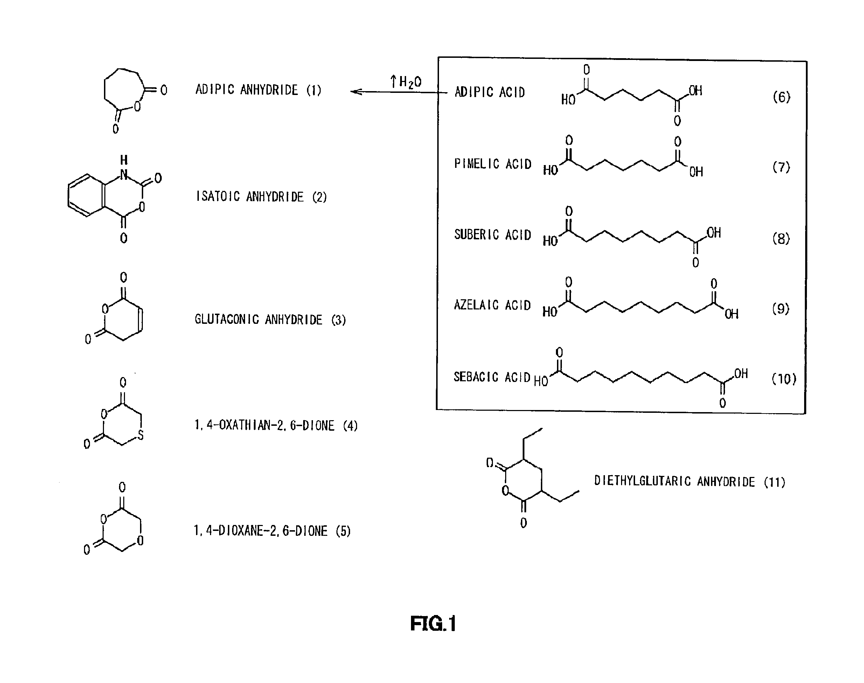

More specifically, as the acid anhydride having a ring structure with 6 or more ring members, as shown in Fig. 1, examples threreof include: adipic anhydride, isatoic anhydride, glutaconic anhydride, 1,4-oxathian-2,6-dione, 1,4-dioxane- 2,6-dione, and diethylglutaric anhydride. Moreover, other examples of the acid anhydride having a ring structure with 6 or more ring members include: pimelic anhydride, suberic anhydride, azelaic anhydride, sebacic anhydride, etc. Among these, the adipic anhydride is obtained by subjecting an adipic acid to an innermolecular dehydration condensation reaction, as shown in Fig. 1. Moreover, the pimelic anhydride, suberic anhydride, azelaic anhydride and sebacic anhydride can be obtained, for example, by respectively subjecting pimelic acid, suberic acid, azelaic acid and sebacic acid, as shown in Fig. 1, to the innermolecular dehydration condensation reaction.

With respect to these acid anhydrides having a ring structure with 6 or more ring members, in the case when the added amount is too small, uncured epoxy compounds tend to become too much, while in the case when the added amount is too large, corrosion of the coated product tends to be accelerated due to an excessive curing agent; therefore, the added amount is preferably set to 4.5% by weight (wt%) or more. That is, the added amount of the acid anhydride having a ring structure with 6 or more ring members is preferably set to 10% or more relative to the entire curing agent component. By using such an added amount, the stress relaxation of the curable resin composition can be improved, thereby making it possible to provide superior peeling resistance and crack resistance.

### <1-3. High Molecular Weight Component>

For the purposes of reducing the elastic modulus of a cured product and of improving the impact resistant property, etc. thereof, the curing resin composition in accordance with the present embodiment contains a high molecular weight component. As this high molecular weight component, for example, an acrylic resin, a rubber (NBR, SBR, NR, SIS, or hydrogenated products thereof) and an olefin resin having a reactive functional group are proposed.

The acrylic resin corresponds to a resin, for example, formed by copolymerizing 2 to 100 parts by weight, preferably, 5 to 70 parts by weight, of glycidyl methacrylate to 100 parts by weight of alkyl(meth)acrylate. Examples of preferable alkyl(meth)acrylates include ethylacrylate, butylacrylate, 2-ethylacrylate, etc.

The weight average molecular weight of the acrylic resin is preferably set to 5000 or more to 200000 or less, more preferably, to 10000 or more to 100000 or less, because, if it is too small, the adhesive strength is lowered, while, if it is too large, the resin is hardly mixed with an alicyclic epoxy compound.

The glass transition temperature of the acrylic resin is preferably set to 50°C or less, more preferably, to 20°C or less, because, if it is too high, the adhesive strength is lowered.

The used amount of the acrylic resin is preferably set at a ratio of 5 to 50 parts by mass, more preferably, 10 to 40 parts by mass, relative to the total 100 parts by weight of an alicyclic epoxy compound, an alicyclic acid anhydride-based curing agent and an acrylic resin, because, if it is too small, the adhesive strength is lowered, while, if it is too large, the optical characteristics are lowered.

### <1-4. Conductive Particles>

A curable resin composition in accordance with the present embodiment contains conductive particles. As the conductive particles, metal coated resin particles in which each of resin particles is coated with a metal material may be used. As these resin particles, styrene-based resin particles, benzoguanamine resin particles, nylon resin particles, etc. are proposed. With respect to the method for coating resin particles with a metal material, conventionally known method can be adopted, and, an electroless-plating method, an electrolytic plating method, etc. may be utilized. The layer thickness of the coating metal material is preferably set to a thickness capable of sufficiently ensuring good connection reliability, and although it depends on particle sizes of the resin particles and kinds of the metal, the thickness is preferably set to 0.1 to 3µm.

The particle size of the conductive particles is preferably set to 1 to 20µm, more preferably, to 3 to 10µm, most preferably, to 3 to 5µm, because, if it is too small, a conduction failure tends to occur, while, if it is large, a short circuit tends to occur between patterns. The shape of the resin particles is preferably a spherical shape; however, a flake shape or a rugby-ball shape may be used.

### <1-5. Other Additives>

A curable resin composition in accordance with the present embodiment may contain a thermal oxidation inhibitor, a curing accelerator, etc., so as to improve the heat resistant property and thermal light resistant property. As the thermal oxidation inhibitor, for example, a hindered phenol-based oxidation inhibitor is proposed. As the curing accelerator, for example, 2-ethyl-4-methyl imidazole is proposed.

### <1-6. Producing Method for Curable Resin Composition>

A curable resin composition in accordance with the present invention can be produced by uniformly dispersing the above-mentioned epoxy adhesive agent, curing agent and acrylic resin, for example, by using a conventionally known method. This curable resin composition can be cured normally by heating it to 150°C to 250°C.

### <2. Other Embodiments Using Curable Resin Composition>

The curable resin composition of the present invention may be processed into a mode, such as a paste mode and a film mode, by using a conventionally known method.

Examples of the paste mode include: an adhesive epoxy resin paste made from the curable resin composition, a die bonding agent and a non-conductive paste made from this adhesive epoxy resin paste, an anisotropic conductive adhesive agent (anisotropic conductive paste) prepared by adding conductive particles into the adhesive epoxy resin paste, etc. For example, the anisotropic conductive film can be produced by uniformly dispersing the above-mentioned epoxy adhesive agent, curing agent, acrylic resin and conductive particles.

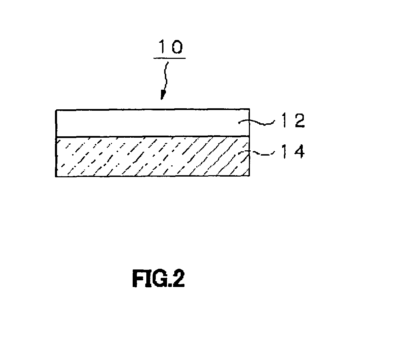

Examples of the film mode include: an adhesive epoxy resin film prepared by molding the curable resin composition into a film, a non-conductive epoxy resin film made of the adhesive epoxy resin film, an anisotropic conductive film prepared by adding conductive particles into the adhesive epoxy resin film, etc. For example, as shown in Fig. 2, an adhesive epoxy resin paste 12, prepared by dispersing and mixing the above-mentioned epoxy adhesive agent, curing agent, acrylic resin and conductive particles with a solvent such as toluene, is applied onto a PET film 14 subjected to a peeling treatment with a predetermined thickness, and dried thereon at a temperature of about 80°C, so that an anisotropic conductive film 10 can be produced.

Moreover, the anisotropic conductive adhesive agent is preferably used for a coupled product formed by coupling chip parts and various modules to a circuit substrate. In particular, a connected structural product, formed by flip-chip assembling chip members, such as IC chips, LED elements or the like, on a circuit substrate by using the anisotropic conductive adhesive agent, makes it possible to maintain high conductive reliability between the circuit substrate and the chip members even under an environment with a heating process of the assembled products, such as a lead-free solder-use reflow process, a thermal impact process, a high-temperature/high-humidity process, or the like. Moreover, the anisotropic conductive adhesive agent makes it possible to maintain a good adhesive property between the circuit substrate as well as the chip members and the cured anisotropic conductive paste. These conduction reliability, adhesive property and the like can be confirmed by using reliability tests, such as high-temperature/high-humidity tests, thermal impact tests (TCT) and the like.

Moreover, the curable resin composition relating to the present embodiment may contain reflective insulating particles for use in externally reflecting incident light.

Examples of the particles having a light reflective property include: metal particles, particles formed by coating metal particles with a resin, inorganic particles, such as metal oxides, metal nitrides and metal sulfides, having gray to white colors under natural light, particles formed by coating resin core particles with inorganic particles, and particles having irregularities on the surface of each particle, although irrespective of its material.

Specific preferable examples of these light reflective insulating particles include: at least one kind of inorganic particles selected from the group consisting of titanium oxide (TiO₂), boron nitride (BN), zinc oxide (ZnO) and aluminum oxide (Al₂O₃). Among these, from the viewpoint of high refractive index, titanium oxide is more preferably used.

As the shape of the light reflective insulating particles, any of a spherical shape, a scale shape, an indefinite shape and a needle shape may be used, and from the viewpoint of reflection efficiency, the spherical shape and scale shape are preferably used. Moreover, in the case of the spherical shape, if the size is too small, the reflectance becomes low, while, if the size is too large, the connection by the conductive particles tends to be blocked; therefore, it is preferably set to 0.02 to 20µm, more preferably, to 0.2 to 1µm; and in the case of the scale shape, the major diameter is preferably set to 0.1 to 100µm, more preferably to 1 to 50µm, while the minor diameter is preferably set to 0.01 to 10µm, more preferably to 0.1 to 5µm, with the thickness being preferably set to 0.01 to 10µm, more preferably to 0.1 to 5µm.

The light reflective insulating particles are preferably designed to have a refractive index (JIS K7142) that is greater than the refractive index of the cured product of the curable resin composition, more preferably, greater than that by at least about a ratio of 0.02. This is because, when the difference in refractive indexes is too small, the reflection efficiency on the interface of these is lowered.

Moreover, as the light reflective insulating particles, resin coated metal particles, prepared by coating the surface of each of scale-shaped or spherical metal particles with a transparent insulating resin, may be used. As the metal particles, nickel, silver, aluminum and the like are proposed. As the shape of the particles, an indefinite shape, a spherical shape, a scale shape, a needle shape or the like may be proposed, and among these, from the viewpoint of a light diffusing effect, the spherical shape is preferably used, and from the viewpoint of a total reflection effect, the scale shape is preferably used. In particular, from the view point of a light reflectance, scale-shaped silver particles are preferably used.

With respect to the size of resin-coated metal particles serving as the light reflective insulating particles, although it also depends on the shapes, in general, if the size is too large, the connection by the conductive particles tends to be blocked, while, if the size is too small, light is hardly reflected; therefore, in the case of the spherical shape, it is preferably set to 0.1 to 30µm, more preferably, to 0.2 to 10µm; and in the case of the scale shape, the major diameter is preferably set to 0.1 to 100µm, more preferably to 1 to 50µm, with the thickness being preferably set to 0.01 to 10µm, more preferably to 0.1 to 5µm. In the case when it is insulation-coated, the size of each light reflective insulating particle includes a size of each insulating particle.

As the resin for these resin-coated metal particles, various kinds of insulating resins may be used. From the viewpoints of mechanical strength and transparency, cured products of the acrylic resins are preferably utilized. More specifically, a resin, prepared by radical-copolymerizing methylmethacrylate and 2-hydroxyethyl methacrylate with each other in the presence of a radical initiator, such as an organic peroxide like benzoylperoxide, is preferably used. In this case, the resin is preferably cross-linked by an isocyanate-based cross-linking agent, such as 2,4-tolylene diisocyanate.

Moreover, with respect to the metal particles, it is preferable to preliminarily introduce a γ-glycidoxy group, a vinyl group, or the like onto the surface of each metal particle by a silane coupling agent.

These resin-coated metal particles can be produced, for example, through processes in which metal particles and a silane coupling agent are charged into a solvent such as toluene, and after having been stirred for about an hour at room temperature, a radical monomer, a radical polymerization initiator, and if necessary, a cross-linking agent, are charged to this and stirred while being heated to a radical polymerization initiating temperature.

With respect to the compounding amount of the above-mentioned light reflective insulating particles, if it is too small, sufficient light reflection is not realized, while, if it is too large, the connection to be caused by the conductive particles used in combination therewith is blocked; therefore, it is preferably set to 1 to 5% by volume, more preferably, to 2 to 25% by volume, in the curable resin composition.

In the case when the curable resin composition of the present embodiment is used as a light reflective anisotropic conductive adhesive agent, such a colorless and transparent resin composition is preferably used. With this arrangement, the light reflection efficiency of the conductive particles, for example, contained in the anisotropic conductive agent is not lowered, and incident light can be reflected without changing the color of incident light. In this case, the colorless and transparent properties mean that, for example, a cured product of the anisotropic conductive adhesive agent has a light transmittance (JIS K7105) of 80% or more, more preferably, 90% or more, per 1 cm of light transmission path relative to a visible light ray with wavelengths of 380 to 780 nm.

With respect to the reflection characteristic of the light reflective anisotropic conductive adhesive agent, in order to improve the light emitting efficiency of light emitting elements, the cured product of the light reflective anisotropic conductive adhesive agent preferably has at least a reflectance (JIS K7105) of 30% or less relative to light having a wavelength of 450 nm. In order to achieve such a reflectance, the reflection characteristic and the compounding amount of the light reflective conductive particles to be used and the compounding composition, etc. of the curable resin composition can be appropriately adjusted.

### <3. EXAMPLES>

### [Examples]

The following description will discuss the present invention by means of specific examples. However, the scope of the present invention is not intended to be limited by any of these examples.

### <Materials>

### · Acrylic resin

Ethyl acrylate (EA100), glycidyl methacrylate (GMA10)

### · Epoxy resin

1,3,5-triglycidyl isocyanurate (TEPIC made by Nissan Chemical Industries, Ltd.), alicyclic epoxy resin (CEL made by Hitachi Chemical Co., Ltd.), glycidyl hexahydrobisphenol A (YX8000 made by JER Co., Ltd.), dicyclopentadiene-based liquid-state epoxy resin (EP4088SS)

### · Curing agent

Methylhexahydroxy phthalic anhydride (MeHHPA made by Shin Nihon Chemical Co., Ltd.), Diethylglutaric anhydride (DEGAN made by Kyowa Hakko Chemical Co., Ltd.

### · Curing accelerator

2-ethyl-4-methyl imidazole (2E4MZ made by Shikoku Kasei Co.)

### · Conductive particles

Particles prepared by Ni/Au plating each of crosslinked polystyrene resin particles having a size of 5µm.

### · Thermal age resistor

Hindered phenolic antioxidant (IRGANOX made by Nihon Ciba-Geigy K.K.)

### <Preparation of Acrylic Resin>

To a four-necked flask having a stirrer and a condenser were loaded 100 g of ethylacrylate (EA), 10 g of glycidyl methacrylate (GMA), 0.2 g of azobisbutyronitrile (AIBN), 300 g of ethyl acetate and 5 g of acetone, and this was polymerized at 70°C for 8 hours while being stirred so that an EA/GMA copolymer acrylic resin was obtained. The resulting acrylic resin had a weight-average molecular weight of 80000, and also had a glass transition temperature of -40°C.

By uniformly mixing components having compounding ratios shown in Table 1 and Table 2 by using a planetary type stirrer, curable resin compositions of examples 1 to 9 and comparative examples 1 to 5 (hereinafter, referred to as "adhesive agent binder cured products") were prepared. Additionally, in Table 1 and Table 2, the unit of each of components of the resin, curing agent and conductive material is parts by weight.

**[Table 1]**

| | | | Example 1 | Example 2 | Example 3 | Example 4 | Example 5 | Example 6 | Example 7 | Example 8 | Example 9 |
|---|---|---|---|---|---|---|---|---|---|---|---|
| Material | Resin | TEPIC | 33 | 33 | 33 | 33 | | | 38 | 30 | 21 |
| | | CEL | | | | | | | | | |
| | | YX8000 | | | | | 39.10 | | | | |
| | | EP4088SS | | | | | | 36.4 | | | |
| | | Acrylic resin | 22 | 22 | 22 | 22 | 26.07 | 24.32 | 10 | 30 | |
| | Curing Agent | MeHHPA | 40.5 | | 22.5 | | 34.83 | 39.19 | 26 | | 14.5 |
| | | DEGAN | 4.5 | 13.5 | | 45 | | | 26 | 20 | 14.5 |
| | Conductive Agent | Conductive particles | 14 | 14 | 14 | 14 | 14 | 14 | 14 | 14 | 14 |
| Outside Appearance | Crack, Peeling | TCT-500cycle | ○ | ○ | ○ | ○ | ○ | ○ | ○ | ○ | ○ |
| | | TCT-1000cycle | ○ | ○ | ○ | ○ | ○ | ○ | ○ | ○ | ○ |
| Electric Characteristic | Conduction Reliability | Initial | ○ | ○ | ○ | ○ | ○ | ○ | ○ | ○ | ○ |
| | | TCT-500cycle | ○ | ○ | ○ | ○ | Δ | ○ | ○ | ○ | ○ |
| | | TCT-1000cycle | ○ | ○ | ○ | ○ | Δ | ○ | ○ | ○ | ○ |
| Physical Properties | Tan δ Maximum Value | -40°C to 100°C | 0.163 | 0.195 | 0.253 | 0.550 | 0.954 | 0.462 | 0.183 | 0.216 | 0.231 |
| | tan δ Value | -40°C | 0.052 | 0.059 | 0.067 | 0.088 | 0.008 | 0.014 | 0.032 | 0.059 | 0103 |
| | tan δ Difference | Maximum value-tan δ Value (-40°C) | 0.111 | 0.136 | 0.186 | 0.462 | 0.947 | 0.447 | 0.151 | 0.157 | 0.128 |
| | tan δ Peak Temperature | | | | 140.2 | 60 | 96.2 | 87.1 | | | |

**[Table 2]**

| | | | Comparative Example 1 | Comparative Example 2 | Comparative Example 3 | Comparative Example 4 | Comparative Example 5 |
|---|---|---|---|---|---|---|---|
| Material | Resin | TEPIC | 33 | 33 | 42 | 17 | |
| | | CEL | | | | | 33.12 |
| | | YX8000 | | | | | |
| | | EP4088SS | | | | | |
| | | Acrylic resin | 22 | 22 | 2 | 60 | 22.08 |
| | Curing Agent | MeHHPA | 45 | 42.75 | 28 | 11.5 | 44.80 |
| | | DEGAN | | 2.25 | 28 | 11.5 | |
| | Conductive Agent | Conductive particles | 14 | 14 | 14 | 14 | 14 |
| Outside Appearance | Crack, Peeling | TCT-500cycle | × | ○ | × | ○ | × |
| | | TCT-1000cycle | - | × | - | × | - |
| Electric Characteristic | Conduction Reliability | Initial | ○ | ○ | ○ | ○ | ○ |
| | | TCT-500cycle | × | ○ | × | ○ | × |
| | | TCT-1000cycle | - | × | × | × | - |
| Physical Properties | tan δ Maximum Value | -40°C to 100°C | 0.112 | 0.123 | 0.092 | 0.238 | 0.116 |
| | tan δ value | -40°C | 0.042 | 0.048 | 0.021 | 0.145 | 0.055 |
| | tan δ Difference | Maximum value-tan δ Value (-40°C) | 0.070 | 0.075 | 0.071 | 0.093 | 0.061 |
| | tan δ Peak Temperature | | 188.5 | | | | 188.5 |

### <Evaluation Test>

With respect to each of adhesive agent binder cured products obtained in examples 1 to 9 as well as in comparative examples 1 to 5, by calculating tan δ as described below, the conduction reliability and the presence or absence of occurrence of cracks were evaluated.

### <Concerning Conduction Reliability>

Onto a glass epoxy circuit substrate, each of paste-state adhesive agent binder cured products obtained in the above-mentioned examples 1 to 9 and comparative example 5 was applied so as to have a thickness of 25µm (thickness in dried state), and an LED chip having a size of 0.3 mm in each side was mounted thereon, and thermally contact-bonded thereto by using a flip-chip bonder. The connected structural product immediately after obtained was measured in its conduction resistance by using a four terminal method. Thereafter, thermal impact tests (TCT: -40°C. 0.5 hour ←→ 100°C. 0.5 hour, 500 cycles, 1000 cycles) were carried out on the connected structural product, and the conduction resistance was again measured. That is, the connected structural product was exposed to an atmosphere of -40°C and an atmosphere of 100°C, for 30 minutes respectively, and with these cooling and heating processes being set to one cycle, 500 cycles or 1000 cycles were carried out.

The evaluation of the conduction reliability, shown in Table 1 and Table 2, was carried out in the following manner: With respect to each of the connected structural products taken out of a TCT after the cycling test, if a Vf value at the time of 20 mA was raised from the initial Vf value by less than ± 0.05 V, this state was evaluated as "o", if it was raised from the initial Vf value in a range from ± 0.05 V or more to ± 0.1 V or less, this state was evaluated as "Δ", and if it was raised from the initial Vf value by ± 0.1 V or more, this state was evaluated as "×".

### <Concerning Crack and Peeling Resistant Properties>

With respect to each of the connected structural products taken out of a TCT after the cycling test, the presence or absence of a peeling on the interface between the LED chip and the binder and a crack in the binder was observed by a metal microscope (made by Olympus Corporation).

With respect to the evaluation on the crack and peeling resistance in Table 1 and Table 2, if neither crack nor peeling was observed, this state was evaluated as "o", while if any crack or peeling was observed, this state was evaluated as "×".

### <Concerning tan δ>

An adhesive agent binder curing product was applied onto a peeling treated PET so as to have a thickness in dried state of 80µm, and this was charged into a furnace at 150°C to be cured so that an adhesive agent binder cured product was obtained.

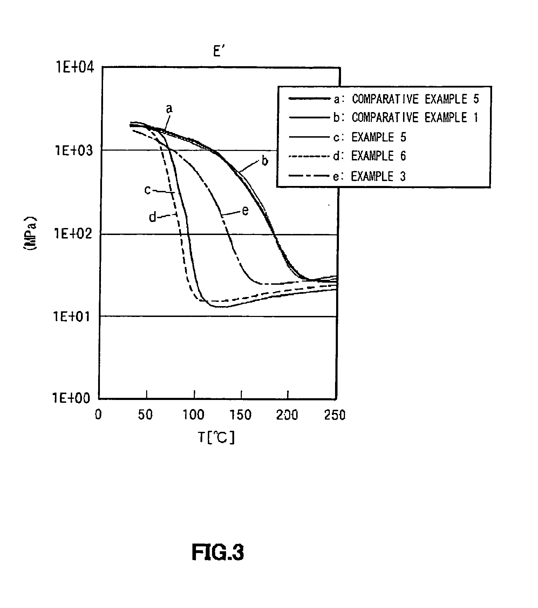

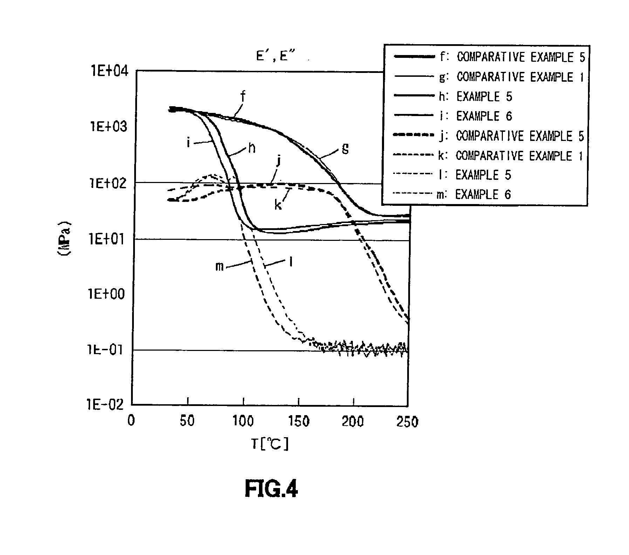

The adhesive agent binder cured product was subjected to a solid viscoelasticity measuring process in a temperature range from -40°C to 250°C so that a viscoelasticity spectrum of the storage elastic modulus (E') relative to a temperature increase shown in Figs. 3 and 4, and a viscoelasticity spectrum of the loss elastic modulus (E") shown in Fig. 4 were obtained.

Fig. 3 shows a viscoelasticity spectrum of the storage elastic modulus (E') of each of comparative example 5(a), comparative example 1(b), example 5(c), example 6(d) and example 3(e).

Fig. 4 shows a viscoelasticity spectrum of the storage elastic modulus (E') of each of comparative example 5(f), comparative example 1(g), example 5(h) and example 6(i). Moreover, Fig. 4 shows a viscoelasticity spectrum of the loss elastic modulus (E") of each of comparative example 5(j), comparative example 1(k), example 5(1) and example 6(m).

In the solid elastic modulus measurements, a dynamic viscoelasticity measuring apparatus (DDV-01FP-W, made by A&D Company, Limited; tension mode, frequency: 11 Hz, temperature-rise rate: 5°C /min.) was used.

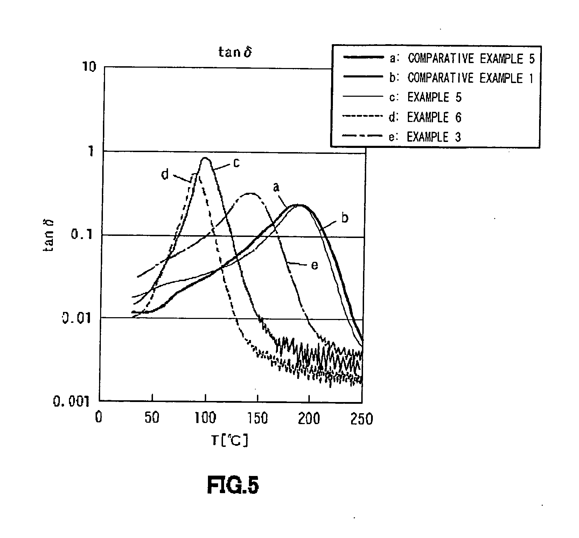

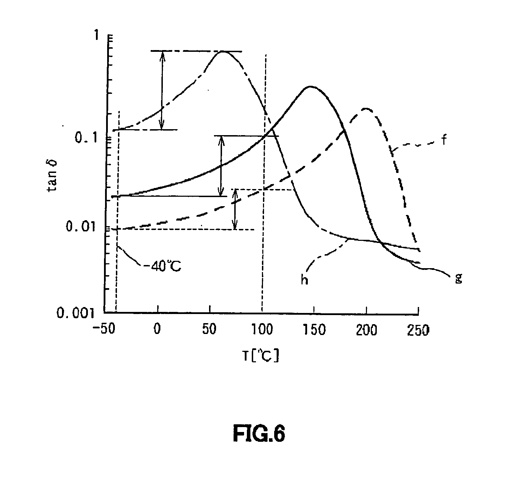

Moreover, from the equation of tan δ = E"/E', values of tanδ (tangent of loss angle) shown in Figs. 5 and 6 were calculated.

Fig. 5 shows the tangent of loss angle tan δ of each of comparative example 5(a), comparative example 1(b), example 5(c), example 6(d) and example 3(e). Fig. 6 shows the tangent of loss angle tan δ of each of comparative example 1 (f), example 3(g) and example 4(h).

In Table 1 and Table 2, the tan δ difference (maximum value-tan δ value (-40°C)) refers to a difference calculated from the maximum value of tan δ and the value of tan δ at -40°C in a temperature range from -40°C to 100°C.

As indicated by Table 1 and Table 2, since the adhesive agent binder cured products obtained in examples 1 to 9 satisfy that the difference between the maximum value of tan δ in a viscoelasticity spectrum and the value of tan δ at -40°C is 0.1 or more, the conduction reliability, crack resistance and peeling resistance are superior.

In the adhesive agent binder cured products obtained in examples 4 to 6, neither cracks nor peelings were observed even after 1500 cycles with respect to the crack resistant and peeling resistant properties, in particular, superior crack resistant and peeling resistant properties were obtained. However, since the adhesive agent binder cured product obtained in example 5 did not satisfy the fact that the difference between the maximum value of tan δ and the value of tan δ at -40°C is 0.1 more and 0.5 or less, the measured Vf value became slightly higher than the initial Vf value in comparison with the other examples.

Moreover, in the adhesive agent binders obtained in examples 1 to 9, since all the cross-linking functional groups were glycidyl groups including those of acrylic resins, for example, as shown in Figs. 5 and 6, the resulting peak of tan δ was only one. In other words, in the adhesive resin binders obtained in examples 1 to 9, since the cross-linking functional groups were allowed to react with one another (all the molecular chains were connected to one another to form a three-dimensional network structure) to form an uniform system so that only one peak was generated.

Since the adhesive agent binder cured product obtained in comparative example 1 did not satisfy the fact that the difference between the maximum value of tan δ and the value of tan δ at -40°C is 0.1 or more, the conduction reliability after 500 cycles of the thermal impact tests was not obtained, although the initial conduction was good. Moreover, in the adhesive agent binder cured product obtained in comparative example 1, interface peelings and cracks were observed after 500 cycles of the thermal impact tests. Therefore, the adhesive agent binder cured product obtained in comparative example 1 was not good in the conduction reliability as well as in the crack resistant and peeling resistant properties.

Since the adhesive agent binder cured product obtained in comparative example 2 did not satisfy the fact that the difference between the maximum value of tan δ and the value of tan δ at -40°C is 0.1 or more, the conduction reliability after 1000 cycles of the thermal impact tests was not obtained, although the initial conduction resistance and the conduction resistance after 500 cycles of the thermal impact tests were good. Moreover, in the adhesive agent binder cured product obtained in comparative example 2, interface peelings and cracks were observed after 1000 cycles of the thermal impact tests. Therefore, the adhesive agent binder cured product obtained in comparative example 2 was not good in the conduction reliability as well as in the crack resistant and peeling resistant properties.

Since the adhesive agent binder cured product obtained in comparative example 3 did not satisfy the fact that the difference between the maximum value of tan δ and the value of tan δ at -40°C is 0.1 or more, the conduction reliability after 500 cycles of the thermal impact tests was not obtained, although the initial conduction was good. Moreover, in the adhesive agent binder cured product obtained in comparative example 3, interface peelings and cracks were observed after 500 cycles of the thermal impact tests. Therefore, the adhesive agent binder cured product obtained in comparative example 3 was not good in the conduction reliability as well as in the crack resistant and peeling resistant properties.

Since the adhesive agent binder cured product obtained in comparative example 4 did not satisfy the fact that the difference between the maximum value of tan δ and the value of tan δ at -40°C is 0.1 or more, the conduction reliability after 1000 cycles of the thermal impact tests was not obtained, although the initial conduction resistance and the conduction resistance after 500 cycles of the thermal impact tests were good. Moreover, in the adhesive agent binder cured product obtained in comparative example 4, interface peelings and cracks were observed after 1000 cycles of the thermal impact tests. Therefore, the adhesive agent binder cured product obtained in comparative example 4 was not good in the conduction reliability as well as in the crack resistant and peeling resistant properties.

Since the adhesive agent binder cured product obtained in comparative example 5 did not satisfy the fact that the difference between the maximum value of tan δ and the value of tan δ at -40°C is 0.1 or more, the conduction reliability after 500 cycles of the thermal impact tests was not obtained, although the initial conduction was good. Moreover, in the adhesive agent binder cured product obtained in comparative example 5, interface peelings and cracks were observed after 500 cycles of the thermal impact tests. Therefore, the adhesive agent binder cured product obtained in comparative example 5 was not good in the conduction reliability as well as in the crack resistant and peeling resistant properties.

As described above, each of the adhesive agent binders obtained in examples 1 to 9 is formed in its composition by allowing an alicyclic epoxy resin to contain 5 to 50 wt% of a high molecular weight component having a reactive functional group and having at least a molecular weight of 5000 or more and 4.5 wt% (10% of its curing agent component) or more of a glutaric anhydride serving as a curing agent, with the difference between the maximum value of tan δ and the value of tan δ at -40°C being set to 0.1 or more. With this arrangement, the present invention makes it possible to provide a flip-chip process-use adhesive agent binder cured product that is suitable for reliability tests such as a lead-free solder-use reflow process, a thermal impact test, or the like, and is applicable to LED peripheral devices that require superior pealing resistant and crack resistant properties and long-term conduction reliability.

## Claims

1. A curable resin composition comprising:
an epoxy resin and an epoxy resin-use curing agent,
wherein a difference between a maximum value of tan δ in a viscoelastic spectrum of the curable resin composition and a value of the tan δ at -40°C thereof is 0.1 or more.

2. The curable resin composition according to Claim 1, wherein the maximum value of tan δ is included in a range from -40°C or more to 100°C or less.

3. The curable resin composition according to Claim 1, wherein the difference between the maximum value of tan δ and a value of the tan δ at -40°C is in a range of 0.1 or more to 0.5 or less.

4. The curable resin composition according to any one of Claims 1 to 3, further comprising:
4.5 wt% or more of an acid anhydride having a ring structure of 6 or more ring members.

5. The curable resin composition according to any one of Claims 1 to 4, further comprising:
4.5 wt% or more of a glutaric anhydride.

6. The curable resin composition according to any one of Claims 1 to 5, further comprising:
5 to 50 wt% of a high molecular weight component having at least a molecular weight of 5000 or more.

7. The curable resin composition according to Claim 6, wherein the high molecular weight component has a Tg of 50°C or less.

8. The curable resin composition according to Claim 6 or 7, wherein the high molecular weight component has a reactive functional group.

9. An adhesive epoxy resin paste comprising: the curable resin composition according to any one of Claims 1 to 8.

10. A die bonding agent comprising: the adhesive resin paste according to Claim 9.

11. A non-conductive paste comprising: the adhesive resin paste according to Claim 9.

12. An adhesive epoxy resin film comprising:
the curable resin composition according to any one of Claims 1 to 8,
wherein the curable resin composition is molded into a film state.

13. A non-conductive epoxy resin film comprising:
the adhesive epoxy resin film according to Claim 12.

14. An anisotropic conductive paste comprising:
the adhesive epoxy resin paste according to Claim 9 that contains conductive particles.

15. An anisotropic conductive film comprising:
the adhesive epoxy resin film according to Claim 12 that contains conductive particles.
